Europäisches Patentamt

European Patent Office

Office européen des brevets

(19)

(11) Publication number: **0 157 675 B1**

# (12) EUROPEAN PATENT SPECIFICATION

(45) Date of publication of patent specification: **12.06.91**   (51) Int. Cl.⁵: **H05K 13/00, H01L 21/00**

(21) Application number: **85400430.6**

(22) Date of filing: **06.03.85**

(54) **Spinning device for processing a substrate, in particular a semiconductor wafer.**

(30) Priority: **06.03.84 JP 42612/84**

(43) Date of publication of application:
**09.10.85 Bulletin 85/41**

(45) Publication of the grant of the patent:
**12.06.91 Bulletin 91/24**

(84) Designated Contracting States:
**DE FR GB**

(56) References cited:
**FR-A- 2 109 716**
**US-A- 4 001 659**

**PATENT ABSTRACTS OF JAPAN vol. 7, no.
21 (E-155) 1166, 27 January 1983 & JP-
A-57-178 327**

(73) Proprietor: **FUJITSU LIMITED**
**1015, Kamikodanaka Nakahara-ku**
**Kawasaki-shi Kanagawa 211(JP)**

(72) Inventor: **Arii, Katsuyuki**
**5-3-12-3, Ochiai**
**Tama-shi Tokyo 206(JP)**

(74) Representative: **Descourtieux, Philippe et al**
**CABINET BEAU de LOMENIE 55 rue**
**d'Amsterdam**
**F-75008 Paris(FR)**

Rank Xerox (UK) Business Services

EP 0 157 675 B1

## Description

BACKGROUND OF THE INVENTION

This invention relates to a spinning device for processing a substrate, in particular a semiconductor wafer in order to manufacture an integrated circuit (IC) device.

Semiconductor wafers undergo various processing steps, during their fabrication, such as formation of a photoresist film thereon, developing of the photoresist layer through selective exposition to ultraviolet light, etching of a silicon oxide layer formed thereon, washing and cleaning to discharge residual treating liquids used. Recently, the size of the pattern formed on semiconductor wafers has become increasingly fine, such as less than one micron, to allow a high packing density on IC substrates. Therefore, it is extremely important to keep the wafers free from micro size defects, namely in order of 0.1 micron, such as various undesired particles, dusts, air bubbles in photoresist films. The different processing steps are frequently performed in sequential, preferably in a single working station, without any physical transfer from one station to another station. This is because it is very difficult to keep a workpiece away from tiny dusts during the transfer. In addition, the processing liquids used, such as etchants are not permitted to leave any residue on the workpiece after the processing.

A spinning method is widely used for the processing of semiconductor wafers in order to meet the above requirements. In particular, the spinning method contributes to enable the use of an automated production line for semiconductor devices, because several consecutive process steps are performed in one spinning work station, using several nozzles for respective processing liquids, and the total number of the fabrication steps is reduced.

Furthermore, for the formation of a photoresist film, spinning coating is suitable to achieve a coating of the wafer with a film having an even and accurate thickness, because the film thickness is relatively easily adjusted by controlling the viscosity of photoresist solvent, the rotating speed, the dispensing speed of the solvent.

Spinners used in the manufacturing of semi-conductor devices generally comprise a spinning disk, a spindle, a cup disposed around the rotating disk, and nozzles for sequentially dispensing different processing liquids onto the center of the disk. A workpiece (semiconductor wafer) is mounted on the spinning disk, being held by a vacuum chuck or other holding means and is caused to rotate at high speed with the spinning disk, while a liquid chemical to be applied, such as a photoresist solvent, a liquid developer, etching liquids, cleaning deionized water is dispensed onto the workpiece by means of respective nozzles. As a result, the liquid chemical spreads on the surface of the workpiece, to form a layer with a thin and uniform thickness due to the strong centrifugal force caused by the high speed spinning, see for example Patent Abstracts of Japan, No 21 (E155) [1166], January 27, 83 and US-A-4001659.

Tiny particles or alien materials left on the surface of the workpiece or air bubbles of micro size embedded in a photoresist layer, cause serious problems in modern IC devices, such as breakdown or shortage of the circuits formed in the devices. In order to eliminate these drawbacks, various methods have been adopted to eliminate such micro-particles from the processing agents. For example, the necessary chemicals are purchased under severe specifications concerning alien material particles mixed therein, the fabrication activity is performed under a strict dust-proof control and, furthermore, fine filters are used to filter the chemical liquids during the fabrication steps. However, since the allowable maximum size of mixed particles of foreign materials or of air bubbles is becoming smaller than one micron, the possibility to overcome the problems by means of the prior art methods is now limited.

SUMMARY OF THE INVENTION

It is an object of the present invention to provide a spinning device which effectively permits to reduce or eliminate particles in chemical liquids, or air bubbles involved in photoresist layers formed on a wafer during fabrication steps of a semiconductor device.

It is another object of the present invention to provide a spinning device allowing to activate the chemical reaction of chemicals such as developing liquids.

It is a further object of the present invention to provide a spinning device by which the fabrication yield of semiconductor wafers can be improved.

These objects are achieved by means of a spinning device which comprises, according to the invention :

- a spinning head rotatable at a specified rotating speed holding a workpiece thereon;
- means for dispensing a liquid material onto said workpiece;

2

- a supersonic power generating means;
- a supersonic vibration transducer embedded in said spinning head; and
- a conducting means for feeding said supersonic power generated in said supersonic power generating means to said supersonic vibration transducer, so that the supersonic vibration can be applied to a liquid material dispensed onto said workpiece.

The frequency of the supersonic vibration is preferably comprised between 100 kHz and 2000 KHz. For example, a frequency of approximately 1000 KHz is found most effective for removing small bubbles contained in an ordinary photoresist layer.

The use of supersonic energy for water cleaning or chemical liquid treatment of workpieces is well known in the art, being found to be effective to eliminate tiny particles attached to the workpiece to be cleaned. The frequency of the supersonic energy is currently of 20 to 40 KHz, rarely up to 80 KHz, mainly because the decay of the supersonic energy injected into the processing liquid is less important in the above frequency range. On the one hand, when the frequency of the supersonic energy travelling in a medium, such as water, increases, the energy increases proportionally to the square of the frequency but, on the other hand, the decay and directivity of the energy in the medium, increases remarkably with the frequency.

However, during the spinning processing of a semiconductor wafer, the thickness of the layer of liquid chemical covering the surface of the wafer is very thin. This is because the liquid is spread towards the periphery of the wafer by the strong centrifugal force generated by the high speed rotation. The supersonic energy is applied perpendicularly to the layer, resulting in a very small travelling path equal to the thickness of the layer. Therefore, the decay and the directivity of the supersonic energy can be neglected. Thus, a supersonic vibration of a higher frequency can be applied to the spinner head.

The supersonic vibration transducer is in the form of a disk, for example of PZT (a solid solution of $PbTiO_3$-$pbZrO_3$), which is embedded in a spinning disk of an insulative material such as ceramics or plastics. The spinning disk is provided with a rotating spindle to which a driving motor is coupled to rotate the disk at a high rotation speed. A pair of power feeding lines transmits the supersonic energy received from a supersonic power generator through an electric ring coupler. The frequency is selected from 200 kHz to 2000kHz depending on the size and character of the chemicals used, materials of the layer and particles to be removed.

The most typical and effective application of the present invention is for the formation of a photoresist layer on a semiconductor wafer. With a photoresist material having a considerable high viscosity from 70 cP to 100 cP, it is difficult to remove air bubbles included in the photoresist layer by using a prior art spinning method.

A frequency of approximately 1000 kHz is most effective to eliminate micro bubbles included in the photoresist layer. In an earlier stage of the spinning operation, after the photoresist material has been dispensed on a workpiece, followed by a relatively slow spinning, thus forming a relatively thick photoresist layer, the supersonic energy is applied to the transducer. By the application of the supersonic energy, most of the small bubbles and small particles trapped on the surface of the wafer, are released from the surface to float into the medium and moved to the periphery of the wafer to be drained together with the excess of photoresist material. Thereafter, the rotating speed is increased to increase the centrifugal force applied to the layer, and, hot nitrogen is introduced to dry the photoresist layer. One experimental result is described hereinafter to show the effect of the applied supersonic energy.

In addition, chemical actions such as developing, chemical etching, chemical cleaning are remarkably accelerated by the vibration occurring in the direction of the axis of the supersonic vibration transducer and a satisfactory reaction between chemicals and the workpiece is performed in a short time.

These objects and advantages which will be apparent from the following description made hereinafter with reference to the accompanying drawings, like reference characters designating same or similar parts throughout the drawings.

## BRIEF DESCRIPTION OF THE DRAWINGS

Fig. 1 is a general view of a spinning device according to the present invention;

Fig. 2 is a cross-sectional view of an embodiment of a spinning device according to the invention used for formation of a photoresist layer;

Fig. 3 is time chart of the application of a supersonic power to a photoresist layer in conjunction with the rotating speed of the spinning disk, during a photoresist layer formation process; and

Fig. 4 is a cross-sectional view of another embodiment of a spinning device according to the invention, for developing the pattern of a photoresist layer exposed to an ultra-violet light.

3

## DESCRIPTION OF PREFERRED EMBODIMENTS

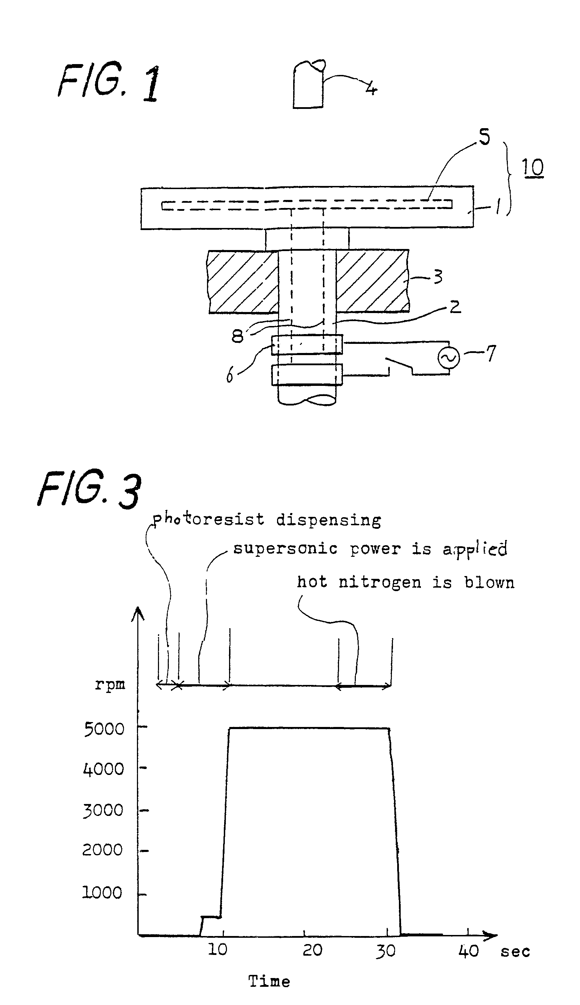

The supersonic spinning device shown in Fig. 1 includes a rotating head block 10 which comprises a ceramic disk 1 and a supersonic vibration transducer disk 5 of PZT (shown with dotted line) embedded in the ceramic disk 1. The head block 10 is mounted on a rotating spindle 2 made of ceramics, the head block 10 being detachable from or attachable to the rotating spindle 2 which is held in rotation by a bearing means 3. Supersonic energy generated by a supersonic power generator 7 is fed to the supersonic vibration transducer disk 5 through a ring coupler 6 mounted around the spindle 2 and feeding means (copper wires) 8 and is applied to terminals (not shown) of the supersonic vibration transducer 5. The transducer 5 converts the supersonic energy to a vibration energy which is applied to the liquid layer. The frequency of the supersonic power is selected depending on the material of the liquid layer and the dimensions of the workpiece. Accordingly, a supersonic power generator of variable frequency is more desirable to meet various requirements for production. The maximum rotating speed is selected to approximately 5000 rpm.

The general operation of the spinning device will be now described referring to Fig. 1. When a chemical liquid is applied to the center of the spinning disk through a nozzle 4, the liquid spread over the workpiece. With the application of supersonic power to the transducer disk 5, micro size particles, contained originally in the chemicals or adhering to the surface of the workpiece, are caused to move upward, or released (peeled off) from the surface of the workpiece by the upward component of the applied supersonic vibration. Then, the spinning head 10 rotates faster, and the chemical liquid (photoresist material for example) is urged toward the periphery of the disk. Thus, the particles or air bubbles are moved to the peripheral region of the spinning disk, and disposed into a cup (not shown, in Fig. 1) mixed with the wasted chemical materials to be drained.

The inventor has found that when a supersonic energy of a relatively low frequency, such as from 20 kHz to 80 kHz, is applied, the surface of the wafer tends to be destroyed or "eroded" with the creation of fine cracks, which might be ascribed to a "cavitation" phenomena. The high energy generated at the collapse of cavitation bubbles is too strong to prevent the surface of the wafer from being destroyed. On the other hand, although the travelling path of the supersonic wave in the liquid medium layer is short, there is a limit to the propagation of the supersonic wave due to the absorption or decay of the high frequency wave. Therefore, the useful frequency range of the supersonic wave in a spinning operation, is preferably from 100 KHz to 2000 KHz.

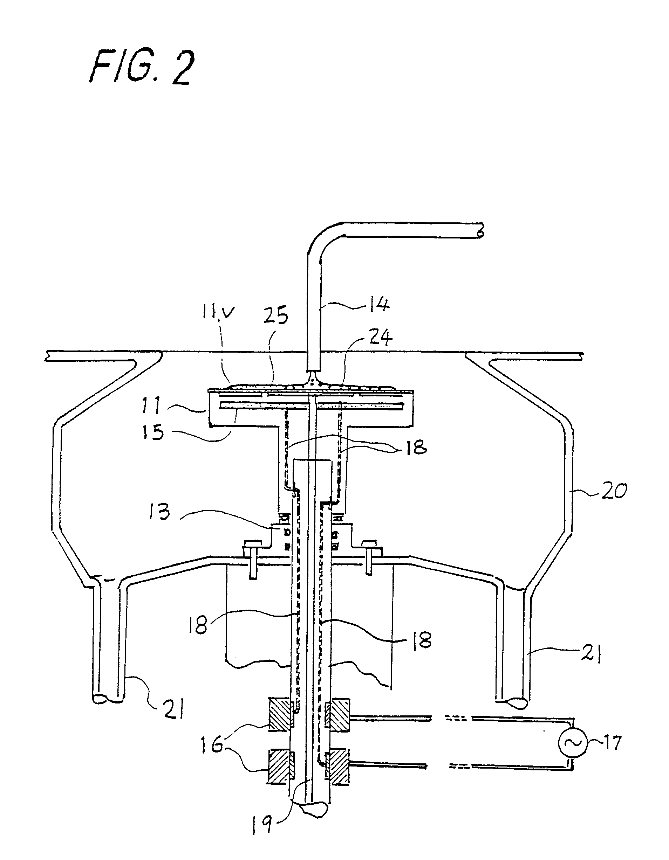

Fig. 2 is schematic cross-sectional view of a spinning device according to the present invention for coating a semiconductor wafer with a photoresist layer. As in the device of Fig. 1, a spinning disk 11, containing a supersonic vibration transducer disk 15 of PZT, is supported rotatably by a complex thrust and journal bearing 13, and driven by a motor (not shown). The upper face of the spinning disk 11 is provided with a vacuum chuck 11v to hold a workpiece thereon. Evacuation for the vacuum chuck 11v is performed through a hole 19 by a conventional rotating vacuum pump (not shown). The supersonic power from the supersonic power generator 17 is fed to the terminals (not shown) of the supersonic vibration transducer through copper conductors 18 and couplers 16. To prevent the radially displaced liquid chemicals from spraying around, a cup assembly 20 is disposed around the spinning disk. Reference numeral 21 denotes a drainage tube means for draining used liquids.

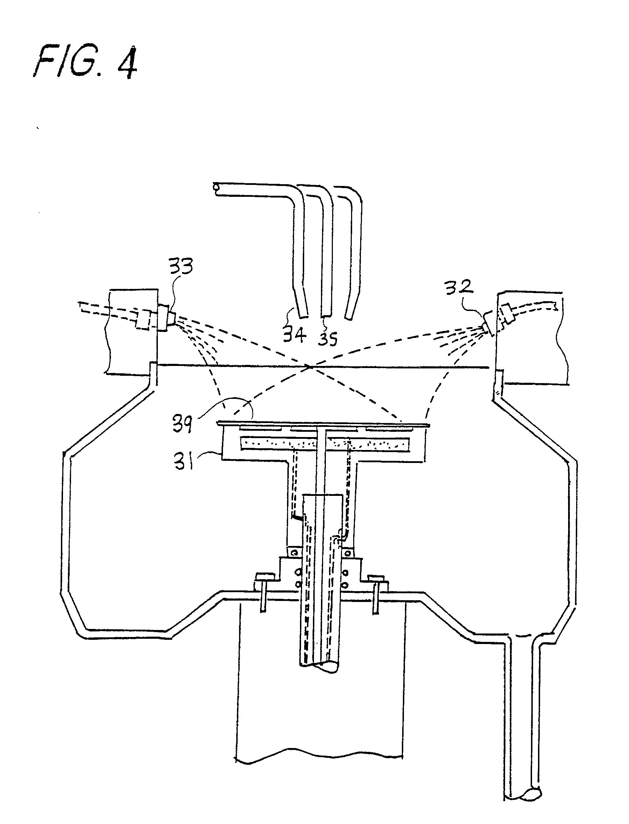

A photoresist material coating process will now be described. A photoresist liquid 24, having a high viscosity, 70 cP to 150 cP for example, is dispensed onto the central portion of a wafer 25 held on the surface of the spinning disk 11 by means of the vacuum chuck 11v. As shown in the time chart of Fig. 3, the supersonic power is applied before starting the rotation of the spinning disk 11, and kept applied at the earlier stage of the rotation where the rotating speed is low, approximately 500 rpm. The micro-sized air bubbles included in the layer as a result of the dispensing step or of preceding fabrication steps, especially bubbles trapped on the surface of the wafer, are released and float into the photoresist layer due to the effect of the supersonic power. The floating bubbles and particles are transported together with the excessive photoresist material to the periphery of the spinning disk 11 and finally drained into the cup assembly 20. Then the spinning disk 11 is accelerated to 5000 rpm and a hot nitrogen gas is introduced to solidify the photoresist layer. If the surface of the wafer sustains a lot of dust particles, it is preferable to remove the dust particles, by dispensing deionized water or cleaning chemicals onto the wafer to clean up the latter before the photoresist coating starts.

Fig. 4 illustrates another embodiment of a spinning device according to the present invention, for performing the developing of a coated photoresist film. After exposing a masked wafer 39 coated with a photoresist layer to an ultraviolet light in order to fix the pattern of the mask, the wafer 39 is held on a spinning disk 31 by means of a vacuum chuck , and a developing solution is sprayed from two nozzles 32

4

and 33, located on the side walls of a cup assembly surrounding the spinning disk 31, as shown in Fig. 4. In this case, the supersonic energy causes an impact in the vertical direction, exciting the chemical reaction between the developing solution and the photoresist material not exposed to the ultraviolet light. As a result, a sharply patterned photoresist layer is obtained in a shorter developing time. In addition, micro-sized particles and small air bubbles are removed substantially from the wafer 39, improving the quality of the processed wafer. The developing process is followed by a rinsing process with deionized water, and a hot air drying process of the patterned photoresist layer on the wafer 39. The deionized water and the hot air are introduced in sequence onto the wafer 39 through respective nozzles 34 and 35 located above the spinning disk 31.

As is apparent to those skilled in the art, the timing of the application of the supersonic power must be determined depending on the material of the workpiece, aspect of the workpiece and the present invention is not confined to the above described embodiments.

Finally, a result of an experiment made will now be described. For this experiment, a supersonic power having a frequency of approximately 600 kHz is used. The supersonic vibration transducer used has a thickness of 2 mm and a lining of aluminium having a thickness of 4 mm. The diameter of the spinning disk head block is approximately 200 mm. The experiment is conducted using a glass plate of 32,25 cm$^2$ 5 in$^2$, with a chromium layer of 60 nm thickness being deposited thereon. The photoresist material used is produced under the reference "OFPR-800" by the TOKYO OOKA-KAGAKU Co.. On the glass plate, 10 cm$^3$ of the photoresist solution with a viscosity of 8 cP are dropped. After spreading of the photoresist material all over the surface of the glass plate, a supersonic vibration is applied to the glass plate for approximately 5 sec using a supersonic vibration transducer of 100 W output, being followed by the application of a spinning of approximately 3000 rpm for 30 sec, to spread away the excessive photoresist material. As a result, there is carried out a satisfactorily uniform pre-baking at approximately 90° C for 30 minutes. A first group of probes are prepared using the same process and another group of probes is prepared using this process except the application of supersonic power. A careful observation is conducted on the two groups of obtained glass plates to examine the number of particles and bubbles left on the probes. The observation is performed with naked eyes using a lamp (day-light with 10,000 Lux) having a safety filter against ultraviolet light to prevent the further photo-sensitive reaction. The results are tabulated as follows :

| | Supersonic energy | |
|---|---|---|
| checking level | applied | not applied |
| no defect | 97 | 73 |
| more than 10 pieces of 1~5μm particles | 2 | 19 |
| more than 1 piece of >6μm particles | 1 | 4 |
| pin hole found | 0 | 4 |
| total number of probes | 100 | 100 |

The experimental results indicate clearly that the application of the supersonic power during a spinning process is very effective to remove particles and air bubbles of small size from the photoresist layer. Especially, it is a significant advantage of the present invention from the view point of the fabrication that no pin hole was found in the pre-baked photoresist layers obtained with application of supersonic power.

**Claims**

1.  A spinning device for processing a substrate, said device comprising :
    a spinning head (1;11;31) rotatable at a specified rotating speed, the head holding a workpiece thereon;
    means (4; 14; 32-33) for dispensing a liquid material onto said workpiece;
    a supersonic power generating means (7;17); said device being characterized in that it comprises :
    a supersonic vibration transducer (5;15) embedded in said spinning head; and
    a conducting means (6,8; 16,18) for feeding said supersonic power generated in said supersonic power generating means to said supersonic vibration transducer, so that supersonic vibration can be applied to a liquid material dispensed onto said workpiece.

2.  A spinning device as claimed in claim 1, characterized in that the frequency of said supersonic power is selected to a value comprised between 100 kHz and 2000 kHz.

3.  A spinning device as claimed in any one of claims 1 and 2, characterized in that said supersonic vibration transducer (5;15) is embedded inside a spinning disk (1; 11; 31) of said spinning head.

4.  A spinning device as claimed in claim 3, characterized in that said spinning disk (1;11; 31) is of an insulating material.

5.  A spinning device according to claim 4, characterized in that said insulating material is selected from ceramics and plastics.

6.  A spinning device according to any one of the preceding claims characterized in that the substrate is a semiconductor wafer.

7.  A spinning device according to claim 6, characterized in that said liquid material is a photoresist material.

**Revendications**

1.  Dispositif d'entraînement en rotation servant à traiter un substrat, ledit dispositif comprenant :
    une tête tournante (1 ; 11 ; 31) pouvant tourner à une vitesse de rotation spécifiée, la tête maintenant sur elle une pièce ;
    un moyen (4 ; 14 ; 32, 33) servant à délivrer une matière liquide sur ladite pièce ;
    un moyen (7 ; 17) générateur de puissance ultrasonore ; ledit dispositif étant caractérisé en ce qu'il comprend :
    un transducteur (5 ; 15) de vibrations ultrasonores encastré dans ladite tête rotative ; et
    un moyen de conduction (6, 8 ; 16, 18) servant à amener ladite puissance ultrasonore produite dans ledit moyen générateur de puissance ultrasonore jusqu'audit transducteur de vibrations ultrasonores, si bien que les vibrations ultrasonores peuvent être appliquées à une matière liquide qui a été délivrée sur ladite pièce.

2.  Dispositif d'entraînement en rotation selon la revendication 1, caractérisé en ce qu'on choisit la fréquence de ladite puissance ultrasonore à une valeur comprise entre 100 kHz et 2 000 kHz.

3.  Dispositif d'entraînement en rotation selon l'une quelconque des revendications 1 et 2, caractérisé en ce que ledit transducteur de vibrations ultrasonores (5 ; 15) est encastré à l'intérieur d'un disque tournant (1 ; 11 ; 31) de ladite tête tournante.

4.  Dispositif d'entraînement en rotation selon la revendication 3, caractérisé en ce que ledit disque tournant (1 ; 11 ; 31) est fait en un matériau isolant.

5.  Dispositif d'entraînement en rotation selon la revendication 4, caractérisé en ce que ledit matériau isolant est choisi parmi les céramiques et les matières plastiques.

6.  Dispositif d'entraînement en rotation selon l'une quelconque des revendications précédentes, caractérisé en ce que le substrat est une pastille semiconductrice.

7. Dispositif d'entraînement en rotation selon la revendication 6, caractérisé en ce que ladite matière liquide est un matériau photosensible du type réserve.

**Ansprüche**

1. Schleudervorrichtung zur Bearbeitung eines Substrates, welche Vorrichtung umfaßt:
   einen Schleuderkopf (1; 11; 31), der mit einer spezifizierten Rotationsgeschwindigkeit rotierbar ist, auf welchem Kopf ein Werkstück gehalten wird;
   Einrichtungen (4; 14; 32-33), um ein flüssiges Material auf das genannte Werkstück abzugeben;
   eine Ultraschallenergiegeneratoreinrichtung (7; 17);
   welche Vorrichtung dadurch gekennzeichnet ist, daß sie umfaßt:
   einen Ultraschallvibrationswandler (5; 15), der in dem genannten Schleuderkopf eingebettet ist; und
   einer leitenden Einrichtung (6, 8; 16, 18), um die genannte Ultraschallenergie, die in der genannten Ultraschallenergiegeneratoreinrichtung erzeugt wird, dem Ultraschallvibrationswandler zuzuführen, so daß Ultraschallvibration auf ein flüssiges Material, welches auf das genannte Werkstück abgegeben wird, angewendet werden kann.

2. Schleudervorrichtung nach Anspruch 1, dadurch gekennzeichnet, daß die Frequenz der genannten Ultraschallenergie ausgewählt ist um einen Wert anzunehmen, der zwischen 100 KHz und 2000 KHz liegt.

3. Schleudervorrichtung nach einem der Ansprüche 1 und 2, dadurch gekennzeichnet, daß der genannte Ultraschallvibrationswandler (5; 15) innerhalb einer Schleuderscheibe (1; 11; 31) des genannten Schleuderkopfes eingebettet ist.

4. Schleudervorrichtung nach Anspruch 3, dadurch gekennzeichnet, daß die genannte Schleuderscheibe (1; 11; 31) aus isolierendem Material besteht.

5. Schleudervorrichtung nach Anspruch 4, dadurch gekennzeichnet, daß das genannte isolierende Material ausgewählt ist aus Keramiken und Kunststoffen.

6. Schleudervorrichtung nach einem der vorhergehenden Ansprüche, dadurch gekennzeichnet, daß das Substrat ein Halbleiterwafer ist.

7. Schleudervorrichtung nach Anspruch 6, dadurch gekennzeichnet, daß das flüssige Material ein Photoresistmaterial ist.

# *FIG. 1*

# *FIG. 3*

photoresist dispensing

supersonic power is applied

hot nitrogen is blown

8

# FIG. 2

*FIG. 4*